# EUROPÄISCHE PATENTSCHRIFT

(11) **EP 0 350 689 B1**
(45) Veröffentlichungstag und Bekanntmachung des Hinweises auf die Patenterteilung: **21.12.1994**
(21) Anmeldenummer: 89111537.0
(22) Anmeldetag: 24.06.1989
(51) Int. Cl.: C08K 13/02, C08L 77/10

(54) **Flammgeschützte thermoplastische Formmassen auf der Basis teilaromatischer Copolyamide**
Flame-retardant thermoplastic moulding compositions based on partially aromatic copolyamides
Compositions à mouler thermoplastiques retardatrices de flamme à base de copolyamides partiellement aromatiques

(30) Priorität: 13.07.1988 EP 88111172
(43) Veröffentlichungstag der Anmeldung: 17.01.1990
(73) Patentinhaber: BASF Aktiengesellschaft, 67063 Ludwigshafen (DE)
(72) Erfinder: Reimann, Horst, Dr., D-6520 Worms 1 (DE); Pipper, Gunter, D-6702 Bad Duerkheim (DE); Weiss, Hans-Peter, Dr., D-6704 Mutterstadt (DE); Plachetta, Christoph, Dr., D-6703 Limburgerhof (DE); Koch, Eckhard Michael, Dr., D-6701 Fussgoenheim (DE); Blinne, Gerd, Dr., D-6719 Bobenheim (DE); Goetz, Walter, Dr., D-6750 Kaiserslautern (DE); Steiert, Peter, Dr., D-6700 Ludwigshafen (DE)

(56) Entgegenhaltungen:
- EP-A- 0 128 341
- EP-A- 0 141 763
- EP-A- 0 299 444

## Beschreibung

Die vorliegende Erfindung betrifft flammfeste thermoplastische Formmassen, enthaltend
A) 40 - 99 Gew.% eines teilaromatischen Copolyamids, aufgebaut aus
   a₁) 40 - 90 Gew.% Einheiten, die sich von Terephthalsäure und Hexamethylendiamin ableiten,
   a₂) 0 - 50 Gew.% Einheiten, die sich von ε-Caprolactam ableiten und
   a₃) 0 - 60 Gew.% Einheiten, die sich von Adipinsäure und Hexamethylendiamin ableiten,
   wobei die Komponente a₂) und/oder a₃) insgesamt mindestens 10 Gew% der Gesamteinheiten ausmachen und nicht mehr als 15 Gew.% an weiteren Polyamidbausteinen, bezogen auf a₁ bis a₃, enthalten,
B) 1 - 40 Gew.% einer Flammschutzmittelkombination aus
   b₁) 40 - 97 Gew.% rotem Phosphor,
   b₂) 1 - 50 Gew.% einer anorganischen Verbindung eines zwei- oder vierwertigen Metalls,
   b₃) 1 - 40 Gew.% einer organischen Mono- oder Dicarbonsäure, und
   b₄) 1 - 40 Gew.% eines Esters einer organischen Carbonsäure mit 6 bis 24 C-Atomen mit einem Alkohol mit 2 bis 24 C-Atomen oder eines Metallsalzes einer solchen Säure oder deren Mischungen
C) 0 - 60 Gew.% faser- oder teilchenförmige Füllstoffe, ausgewählt aus der Gruppe aus Glasfasern, Kohlenstoffasern, Aramid-Fasern, Kaliumtitanatfasern, faser- oder teilchenförmige Silikate, Quarzmehl, Bornitrid, Kaolin, Glaskugeln oder deren Mischungen, und
D) 0 - 40 Gew.% eines schlagzäh modifizierenden Polymeren.

Aus der EP-A 92776 ist ein Verfahren Zum Flammfestausrüsten von Polyamiden bekannt, nach welchem als Flammschutzmittel 1 - 10 Gew.% roter Phosphor und 0,005 - 8 Gew.% einer anorganischen oder organischen Verbindung eines zwei- oder vierwertigen Metalls in das Polyamid eingearbeitet werden. Die Metallverbindung wird dabei als Konzentrat in einem Polyolefinhomo- oder Copolymerisat eingesetzt.

Bei der Anwendung dieses Verfahrens bei der Flammfestausrüstung von Polyamiden mit hohen Schmelzpunkten (>270°C) treten jedoch Probleme auf, da die Stabilität des roten Phosphors nicht mehr ausreichend gegeben ist. Dies führt zu unerwünschten Auf- und Abbaureaktionen der Komponenten, die letztlich auch die mechanischen Eigenschaften der Endprodukte beeinflussen.

Hinzu kommt, daß die Olefinhomo- oder copolymerisate bei höheren Temperaturen nicht mehr ausreichend stabil sind, was u.a. zu Farbveränderungen der Endprodukte führen kann.

Aus der EP-A 141 763 sind Formmassen bekannt, die als Flammschutzmittel eine Kombination aus rotem Phosphor und einer Lanthanidverbindung enthalten. Diese Lanthanidverbindungen verteuern die Produkte selbst bei Anwendung in geringer Menge beträchtlich und für Polyamide mit höheren Schmelztemperaturen treten auch in diesen Systemen Stabilitätsprobleme auf.

Aufgabe der vorliegenden Erfindung war es daher, teilaromatische Copolyamide mit relativ hohem Schmelzpunkt mit rotem Phosphor flammfest auszurüsten, ohne daß Stabilitätsprobleme auftreten. Darüber hinaus sollten die Produkte auch ein insgesamt ausgewogenes Eigenschaftsprofil aufweisen.

Diese Aufgabe wird erfindungsgemäß durch die eingangs definierten thermoplastischen Formmassen gelöst. Bevorzugte Massen dieser Art sind den Unteransprüchen zu entnehmen.

Als Komponente A enthalten die erfindungsgemäßen thermoplastischen Formmassen 40 - 99, vorzugsweise 50 - 95 und insbesondere 55 - 90 Gew.% eines teilaromatischen Copolyamids aufgebaut aus
a₁) 40 - 90 Gew.% Einheiten, die sich von Terephthalsäure und Hexamethylendiamin ableiten,
a₂) 0 - 50 Gew.% Einheiten, die sich von ε-Caprolactam ableiten und
a₃) 0 - 60 Gew.% Einheiten, die sich von Adipinsäure und Hexamethylendiamin ableiten,
wobei die Komponente a₂) und/oder a₃) insgesamt mindestens 10 Gew.% der Gesamteinheiten ausmachen.

Die teilaromatischen Copolyamide enthalten als Komponente a₁) 40 - 90 Gew.% Einheiten, die sich von Terephthalsäure und Hexamethylendiamin ableiten. Ein geringer Anteil der Terephthalsäure, vorzugsweise nicht mehr als 10 Gew.% der gesamten eingesetzten aromatischen Dicarbonsäure, kann durch Isophthalsäure oder andere aromatische Dicarbonsäuren, vorzugsweise solche, in denen die Carboxylgruppen in para-Stellung stehen, ersetzt werden.

Neben den Einheiten, die sich von Terephthalsäure und Hexamethylendiamin ableiten, enthalten die Copolyamide Einheiten, die sich von ε-Caprolactam ableiten und/oder Einheiten, die sich von Adipinsäure und Hexamethylendiamin ableiten.

Der Anteil an Einheiten, die sich von ε-Caprolactam ableiten, beträgt maximal 50 Gew.%, vorzugsweise 20 - 50 Gew.%, insbesondere 25 - 40 Gew.%, während der Anteil an Einheiten, die sich von Adipinsäure und Hexamethylendiamin ableiten, bis zu 60 Gew.%, vorzugsweise 30 - 60 Gew.% und insbesondere 35 - 55 Gew.% beträgt.

Die Copolyamide A) können auch sowohl Einheiten von ε-Caprolactam als auch Einheiten von Adipinsäure und Hexamethylendiamin enthalten; in diesem Fall ist darauf zu achten, daß der Anteil an Einheiten, die frei von aromatischen Gruppen sind, mindestens 10 Gew.% beträgt, vorzugsweise mindestens 20 Gew.%. Das Verhältnis der Einheiten, die sich von ε-Caprolactam und von Adipinsäure und Hexamethylendiamin ableiten, unterliegt dabei keiner besonderen Beschränkung.

Bevorzugt werden Copolyamide, deren Zusammensetzung im Dreistoffdiagramm innerhalb des durch Eckpunkte X₁ bis X₅ festgelegten Fünfecks liegt, wobei die Punkte X₁ bis X₅ folgendermaßen definiert sind:
- X₁: 40 Gew.% Einheiten a₁)
60 Gew.% Einheiten a₃)
- X₂: 60 Gew.% Einheiten a₁)
40 Gew.% Einheiten a₃)
- X₃: 80 Gew.% Einheiten a₁)
5 Gew.% Einheiten a₂)
15 Gew.% Einheiten a₃)
- X₄: 80 Gew.% Einheiten a₁)
20 Gew.% Einheiten a₂)
- X₅: 50 Gew.% Einheiten a₁)
50 Gew.% Einheiten a₂)
In der Abbildung ist das durch diese Punkte festgelegte Fünfeck in einem Dreistoffdiagramm dargestellt.

Als besonders vorteilhaft für viele Anwendungszwecke haben sich Polyamide mit 50 - 80, insbesondere 60 - 75 Gew.% Einheiten, die sich von Terephthalsäure und Hexamethylendiamin ableiten (Einheiten a₁)) und 20 - 50, vorzugsweise 25 - 40 Gew.% Einheiten, die sich von ε-Caprolactam ableiten (Einheiten a₂)), erwiesen.

Neben den vorstehend beschriebenen Einheiten a₁) bis a₃) können die teilaromatischen Copolyamide noch untergeordnete Mengen, vorzugsweise nicht mehr als 15 Gew.%, insbesondere nicht mehr als 10 Gew.%, an weiteren Polyamidbausteinen enthalten, wie sie von anderen Polyamiden bekannt sind. Diese Bausteine können sich von Dicarbonsäuren mit 4 bis 16 Kohlenstoffatomen und aliphatischen oder cycloalphatischen Diaminen mit 4 bis 16 Kohlenstoffatomen sowie von Aminocarbonsäuren bzw. entsprechenden Lactamen mit 7 - 12 Kohlenstoffatomen ableiten. Als geeignete Monomere dieser Typen seien hier nur Suberinsäure, Azelainsäure, Sebacinsäure oder Isophthalsäure als Vertreter der Dicarbonsäuren, 1,4-Butandiamin, 1,5-Pentandiamin, Piperazin, 4,4'-Diaminodicyclohexylmethan, 2,2-(4,4'-Diaminodicyclohexyl)propan oder 3,3'-Dimethyl-4,4'-diaminodicyclohexylmethan als Vertreter der Diamine und Capryllactam, Önanthlactam, Omega-Aminoundecansäure und Laurinlactam als Vertreter von Lactamen bzw. Aminocarbonsäuren genannt.

Vorteilhafte teilaromatische Copolyamide weisen einen Triamingehalt von weniger als 0,5, vorzugsweise weniger als 0,3 Gew.%, auf.

Nach den meisten bisher bekannten Verfahren hergestellte teilaromatische Copolyamide weisen Triamingehalte auf, die über 0,5 Gew.% liegen, was zu einer Verschlechterung der Produktqualität und zu Problemen bei der kontinuierlichen Herstellung führen kann. Als Triamin, welches diese Probleme verursacht, ist insbesondere das Dihexamethylentriamin zu nennen, welches sich aus dem bei der Herstellung eingesetzten Hexamethylendiamin bildet.

Die Schmelzpunkte der teilaromatischen Copolyamide A liegen im Bereich von 270°C bis über 300°C, wobei dieser hohe Schmelzpunkt auch mit einer hohen Glasübergangstemperatur von in der Regel mehr als 75, insbesondere mehr als 85°C verbunden ist.

Binäre Copolyamide auf der Basis von Terephthalsäure, Hexamethylendiamin und ε-Caprolactam weisen bei Gehalten von etwa 70 Gew.% an Einheiten, die sich von Terephthalsäure und Hexamethylendiamin ableiten, Schmelzpunkte im Bereich von 300°C und eine Glasübergangstemperatur von mehr als 110°C auf.

Binäre Copolyamide auf der Basis von Terephthalsäure, Adipinsäure und Hexamethylendiamin erreichen bereits bei niedrigeren Gehalten von etwa 55 Gew.% Einheiten aus Terephthalsäure und Hexamethylendiamin Schmelzpunkte von 300°C und mehr, wobei die Glasübergangstemperatur nicht ganz so hoch liegt wie bei binären Copolyamiden, die anstelle von Adipinsäure bzw. Adipinsäure/HMD ε-Caprolactam enthalten.

Die Herstellung der teilaromatischen Copolyamide kann z.B. nach dem in den EP-A 129 195 und 129 196 beschriebenen Verfahren erfolgen.

Gemäß diesem Verfahren wird eine wäßrige Lösung der Monomeren, d.h. in diesem Fall der Monomeren, die die Einheiten a₁) bis a₃) bilden, unter erhöhtem Druck unter gleichzeitiger Verdampfung von Wasser und Bildung eines Präpolymeren auf eine Temperatur von 250 - 300°C erhitzt, anschließend werden Präpolymere und Dämpfe kontinuierlich getrennt, die Dämpfe rektifiziert und die mitgeführten Diamine zurückgeleitet. Schließlich wird das Präpolymer in eine Polykondensationszone geleitet und unter einem Überdruck von 1 - 10 bar und einer Temperatur von 250 - 300°C polykondensiert. Wesentlich ist bei dem Verfahren, daß die wäßrige Salzlösung unter einem Überdruck von 1 - 10 bar innerhalb einer Verweilzeit von weniger als 60 Sekunden erhitzt wird, wobei bei Austritt aus der Verdampferzone der Umsetzungsgrad vorteilhaft mindestens 93 % und der Wassergehalt des Präpolymeren höchstens 7 Gew.% beträgt.

Durch diese kurzen Verweilzeiten wird die Bildung von Triaminen weitgehend verhindert.

Die verwendeten wäßrigen Lösungen haben in der Regel einen Monomergehalt von 30 - 70 Gew.%, insbesondere von 40 - 65 Gew.%.

Die wäßrige Salzlösung wird vorteilhaft mit einer Temperatur von 50 - 100°C kontinuierlich in eine Verdampferzone geleitet, wo die wäßrige Salzlösung unter einem Überdruck von 1 - 10, vorzugsweise von 2 - 6 bar auf eine Temperatur von 250 - 330°C erhitzt wird. Es versteht sich, daß die angewandte Temperatur über dem Schmelzpunkt des jeweils herzustellenden Polyamids liegt.

Wie bereits erwähnt, ist es wesentlich, daß die Verweilzeit in der Verdampferzone maximal 60 Sekunden, vorzugsweise 10 - 55 Sekunden und insbesondere 10 - 40 Sekunden beträgt.

Der Umsatz beim Austritt aus der Verdampferzone beträgt mindestens 93, vorzugsweise 95 - 98 % und der Wassergehalt liegt vorzugsweise im Bereich von 2 - 5, insbesondere 1 - 3 Gew.%.

Die Verdampferzone ist vorteilhaft als Röhrenbündel ausgebildet. Besonders bewährt haben sich Röhrenbündel, in denen der Querschnitt der einzelnen Röhren periodisch wiederkehrend rohrförmig und spaltförmig ausgebildet ist.

Ferner hat es sich als vorteilhaft erwiesen, das Gemisch aus Präpolymeren und Dampf vor der Trennung der Phasen unmittelbar nach der Verdampferzone durch eine röhrenförmige Stoffaustauschzone, die mit Einbauten versehen ist, zu leiten. Hierbei hält man die in der Verdampferzone angewandten Temperaturen und Druckbedingungen ein. Die Einbauten, z.B. Füllkörper wie Raschigringe, Metallringe oder insbesondere Füllkörper aus Drahtnetz, bewirken eine große Oberfläche. Hierdurch werden die Phasen, d.h. Präpolymeres und Dampf, innig in Berührung gebracht. Dies bewirkt, daß die Menge des mit Wasserdampf freigesetzten Diamins erheblich vermindert wird. In der Regel hält man in der Stoffaustauschzone eine Verweilzeit von 1 bis 15 Minuten ein. Die Stoffaustauschzone ist vorteilhaft als Röhrenbündel ausgebildet.

Das aus der Verdampferzone bzw. Stoffaustauschzone austretende zweiphasige Gemisch aus Dampf und Präpolymeren wird getrennt. Die Trennung erfolgt in der Regel von selbst aufgrund der physikalischen Unterschiede in einem Gefäß, wobei der untere Teil des Gefäßes vorteilhaft als Polymerisationszone ausgebildet ist. Die freiwerdenden Brüden bestehen im wesentlichen aus Wasserdampf und Diaminen, die bei dem Verdampfen des Wassers freigesetzt wurden. Diese Brüden werden in eine Kolonne geleitet und rektifiziert. Geeignete Kolonnen sind beispielsweise Füllkörperkolonnen, Glockenbodenkolonnen oder Siebbodenkolonnen mit 5 bis 15 theoretischen Böden. Die Kolonne wird zweckmäßig unter den identischen Druckbedingungen wie die Verdampferzone betrieben. Die in den Brüden enthaltenen Diamine werden hierbei abgetrennt und wieder der Verdampferzone zugeführt. Es ist auch möglich, die Diamine der nachfolgenden Polymerisationszone zuzuführen. Der anfallende rektifizierte Wasserdampf wird am Kopf der Kolonne entnommen.

Das erhaltene Präpolymere, das entsprechend seinem Umsetzungsgrad im wesentlichen aus niedermolekularem Polyamid und gegebenenfalls restlichen Mengen an nicht umgesetzten Salzen besteht und in der Regel eine relative Viskosität von 1,2 - 1,7 hat, wird in eine Polymerisationszone geleitet. In der Polymerisationszone wird die anfallende Schmelze bei einer Temperatur von 270 - 330°C, insbesondere 270 - 310°C, und unter einem Überdruck von 1 - 10 bar, insbesondere 2 - 6 bar, polykondensiert. Vorteilhaft werden die hierbei freiwerdenden Dämpfe zusammen mit den obengenannten Brüden in der Kolonne rektifiziert, vorzugsweise hält man in der Polykondensationszone eine Verweilzeit von 5 - 30 Minuten ein. Das so erhaltene Polyamid, das in der Regel eine relative Viskosität von 1,2 - 2,3 hat, wird kontinuierlich aus der Kondensationszone entnommen.

Nach einer bevorzugten Arbeitsweise leitet man das so erhaltene Polyamid schmelzflüssig durch eine Austragszone unter gleichzeitiger Entfernung des in der Schmelze enthaltenen Restwassers. Geeignete Austragszonen sind beispielsweise Entgasungsextruder. Die so vom Wasser befreite Schmelze wird dann in Stränge gegossen und granuliert. Das erhaltene Granulat wird vorteilhaft in fester Phase mittels überhitztem Wasserdampf bei einer Temperatur unterhalb des Schmelzpunktes, z.B. von 170 - 240°C, bis zur gewünschten Viskosität kondensiert. Vorteilhaft verwendet man hierfür den am Kopf der Kolonne anfallenden Wasserdampf.

Die relative Viskosität, gemessen in 1 % Lösung (1 g/100 ml) in 96 Gew.% H₂SO₄ bei 23°C, liegt nach der Festphasennachkondensation im allgemeinen im Bereich von 2,2 - 5,0, vorzugsweise von 2,3 - 4,5.

Nach einer anderen bevorzugten Arbeitsweise wird die aus der Polykondensationszone ausgetragene Polyamidschmelze in eine weitere Polykondensationszone geleitet und dort unter fortlaufender Ausbildung neuer Oberflächen bei einer Temperatur von 285 bis 310°C vorteilhaft unter vermindertem Druck, z.B. von 1 - 500 mbar, bis zur gewünschten Viskosität kondensiert. Geeignete Vorrichtungen sind als Finisher bekannt.

Als Komponente B enthalten die erfindungsgemäßen Formmassen 1 - 40, vorzugsweise 3 - 30 und insbesondere 5 - 25 Gew.% einer Flammschutzmittelkombination aus den Komponenten b₁) bis b₄). Bei der Komponente b₁), die 40 - 97, vorzugsweise 50 - 95 und insbesondere 55 - 90 Gew.% der Flammschutzmittelkombination B ausmacht, handelt es sich um roten Phosphor, welcher als Flammschutzmittel für Polyamide an sich bekannt ist. Als roter Phosphor kann unbehandelter roter Phosphor oder aber oberflächlich mit Silikonöl, Paraffinöl, Estern der Phthalsäure oder Adipinsäure, Phenolharzen, Aminoplasten oder Polyurethanen beschichteter roter Phosphor eingesetzt werden.

Die Einarbeitung des roten Phosphors kann direkt oder in Form eines Konzentrats im teilaromatischen Copolyamid oder ggf. einem anderen Polyamid erfolgen.

Entsprechende Phosphor-Produkte wie auch Verfahren zur Einarbeitung sind dem Fachmann an sich bekannt und in der Literatur beschrieben.

Bei der Komponente b₂) handelt es sich um eine anorganische Verbindung eines zwei- oder vierwertigen Metalls; der Mengenanteil beträgt 1 - 50, vorzugsweise 3 - 40 und insbesondere 5 - 30 Gew.%, bezogen auf das Gewicht der Flammschutzmittelkombination B. Bevorzugte Verbindungen b₂) sind Oxide, Carbonate und Oxicarbonate der Metalle Zink, Cadmium, Aluminium, Titan oder Magnesium, insbesondere bevorzugt werden Zinkoxid und Cadmiumoxid, wobei Zinkoxid wegen seiner toxikologischen Vorteile häufig vorzuziehen ist.

Die Mono- oder Dicarbonsäure b₃) macht 1 - 40, vorzugsweise 1 - 30 und insbesondere 2 - 10 Gew.% der Flammschutzmittelkombination B aus.

Als Beispiele für Dicarbonsäuren seien Oxalsäure, Malonsäure, Fumarsäure, Maleinsäure, Adipinsäure, Sebazinsäure und Palmitinsäure genannt, wovon die beiden letztgenannten Säuren, insbesondere Sebazinsäure bevorzugt werden. Selbstverständlich kann auch eine Mischung mehrerer Säuren eingesetzt werden.

Als Komponente b₃) können prinzipiell auch Monocarbonsäuren eingesetzt werden (z.B. Acrylsäure, Methacrylsäure) doch werden Dicarbonsäuren wegen der besseren Ergebnisse im allgemeinen bevorzugt.

Die Komponente b₄) macht 1 - 40, vorzugsweise 2 - 25 und insbesondere 3 - 20 Gew.%, bezogen auf das Gesamtgewicht der Flammschutzmittelkombination B aus.

Bei den organischen Säuren mit 6 - 24 C-Atomen, deren Ester als Komponente b₄) geeignet sind, handelt es sich vorzugsweise um Pelargonsäure, Palmitinsäure, Laurinsäure, Margarinsäure, Adipinsäure, Dodecandisäure oder Stearinsäure, wobei Stearinsäure im allgemeinen bevorzugt wird. Diese werden vorzugsweise mit n-Butanol, n-Octanol, Stearylalkohol, Ethylenglykol, Neopentylglykol, Glycerin und Pentaerythrit, insbesondere Stearylalkohol und Glycerin verestert, um die Ester b₄) zu erhalten.

Aus dem Vorstehenden ergibt sich, daß Stearylstearat und Glycerinmonostearat bevorzugte Ester sind.

Anstelle der Ester können auch Metallsalze solcher Säuren eingesetzt werden, insbesondere Aluminium-, Calcium- oder Zinksalze. Es versteht sich, daß als Komponente b₄) Mischungen verschiedener Ester oder verschiedener Metallsalze oder Mischungen aus Estern und Metallsalzen eingesetzt werden können.

Als Komponente C können die erfindungsgemäßen thermoplastischen Formmassen bis zu 60, vorzugsweise 5 - 50 und insbesondere 10 - 40 Gew.% faser- oder teilchenförmige Füllstoffe oder deren Mischungen enthalten.

Als faserförmige Füllstoffe seien hier nur beispielsweise Glasfasern, Kohlenstoff-Fasern, Aramid-Fasern, Kaliumtitanatfasern und faserförmige Silikate wie Wollastonit genannt.

Bei der Verwendung von Glasfasern können diese zur besseren Verträglichkeit mit dem Polyamid mit einer Schlichte und einem Haftvermittler ausgerüstet sein.

Im allgemeinen haben die verwendeten Glasfasern einen Durchmesser im Bereich von 6 - 20 µm. Die Einarbeitung kann sowohl in Form von Kurzglasfasern als auch in Form von Endlossträngen (Rovings) erfolgen. Im fertigen Spritzgußteil liegt die mittlere Länge der Glasfasern vorzugsweise im Bereich von 0,08 bis 5 mm.

Als teilchenförmige Füllstoffe seien hier nur stellvertretend Glaskugeln, teilchenförmiger Wollastonit, Quarzmehl, Bornitrid, Kaolin, genannt, wovon Wollastonit, und Kaolin im allgemeinen bevorzugt werden.

Als Komponente (D) können die erfindungsgemäßen thermoplastischen Formmassen bis zu 40, vorzugsweise bis zu 3 - 25 Gew.% eines schlagzäh modifizierendem Polymeren enthalten.

Bevorzugte schlagzäh modifizierende Polymere (kautschukelastische Polymerisate) sind Polymerisate auf Basis von Olefinen, die aus folgenden Komponenten aufgebaut sind:
d₁) 40-100 Gew.% mindestens eines α-Olefins mit 2-8 C-Atomen
d₂) 0-50 Gew.% eines Diens
d₃) 0-45 Gew.% eines C₁-C₁₂-Alkylesters der Acrylsäure oder Methacrylsäure oder Mischungen derartiger Ester,
d₄) 0-40 Gew.% einer ethylenisch ungesättigen Mono-oder Dicarbonsäure oder einem funktionellen Derivat einer solchen Säure
d₅) 0-40 Gew.% eines Epoxygruppen enthaltenden Monomeren,
d₆) 0-5 Gew.% sonstiger radikalisch polymerisierbaren Monomerer,
mit der Maßgabe, daß die Komponente (D) kein Olefinhomopolymerisat ist, denn hiermit, z.B. mit Polyethylen, erzielt man die vorteilhaften Wirkungen bei der Verbesserung der Zähigkeitseigenschaften nicht in gleichem Maße.

Als erste bevorzugte Gruppe sind die sogenannten Ethylen-Propylen-(EPM)- bzw. Ethylen-Propylen-Dien-(EPDM)-Kautschuke zu nennen, die vorzugsweise ein Verhältnis von Ethylen- zu Propyleneinheiten im Bereich von 40:60 bis 90:10 aufweisen.

Die Mooney-Viskositäten (MLI+4/100°C) solcher, vorzugsweise unvernetzter, EPM- bzw. EPDM-Kautschuke (Gelgehalte im allgemeinen unter 1 Gew.%) liegen bevorzugt im Bereich von 25 bis 100, insbesondere von 35 bis 90 (gemessen am großen Rotor nach 4 Minuten Laufzeit bei 100°C nach DIN 53 523).

EPM-Kautschuke haben im allgemeinen praktisch keine Doppelbindungen mehr, während EPDM-Kautschuke 1 bis 20 Doppelbindungen/100 C-Atome aufweisen können.

Als Dien-Monomere d₂) für EPDM-Kautschuke seien beispielsweise konjugierte Diene wie Isopren und Butadien, nicht-konjugierte Diene mit 5 bis 25 C-Atomen wie Penta-1,4-dien, Hexa-1,4-dien, Hexa-1,5-dien, 2,5-Dimethylhexa-1,5-dien und Octa-1,4-dien, cyclische Diene wie Cyclopentadien, Cyclohexadiene, Cyclooctadiene und Dicyclopentadien sowie Alkenylnorbornene wie 5-Ethyliden-2-norbornen, 5-Butyliden-2-norbornen, 2-Methallyl-5-norbornen, 2-Isopropenyl-5-norbornen und Tricyclodiene wie 3-Methyl-tricyclo(5.2.1.0.2.6)-3,8-decadien oder deren Mischungen genannt. Bevorzugt werden Hexa-1,5-dien-5-Ethyliden-norbornen und Dicyclopentadien. Der Diengehalt der EPDM-Kautschuke beträgt vorzugsweise 0,5 bis 50, insbesondere 2 bis 20 und besonders bevorzugt 3 bis 15 Gew.%, bezogen auf das Gesamtgewicht des Olefinpolymerisats.

EPM- bzw. EPDM-Kautschuke können vorzugsweise auch mit reaktiven Carbonsäuren oder deren Derivaten gepfropft sein. Hier seien vor allem Acrylsäure, Methacrylsäure und deren Derivate sowie Maleinsäureanhydrid genannt.

Eine weitere Gruppe bevorzugter Olefinpolymerisate sind Copolymere von α-Olefinen mit 2-8 C-Atomen, insbesondere des Ethylens, mit C₁-C₁₈-Alkylestern der Acrylsäure und/oder Methacrylsäure.

Grundsätzlich eignen sich alle primären, sekundären und tertiären C₁-C₁₈-Alkylester der Acrylsäure oder Methacrylsäure, doch werden Ester mit 1-12 C-Atomen, insbesondere mit 2-10 C-Atomen bevorzugt.

Beispiele hierfür sind Methyl-, Ethyl-, Propyl-, n-, i-Butyl- und t-Butyl-, 2-Ethylhexyl-, Octyl- und Decylacrylate bzw. die entsprechenden Ester der Methacrylsäure. Von diesen werden n-Butylacrylat und 2-Ethylhexylacrylat besonders bevorzugt.

Der Anteil der Methacrylsäureester und Acrylsäureester d₃) an den Olefinpolymerisaten beträgt 0 - 60, vorzugsweise 10 - 50 und insbesondere 30 - 45 Gew.%.

Anstelle der Ester d₃) oder zusätzlich zu diesen können in den Olefinpolymerisaten auch säurefunktionelle und/oder latent säurefunktionelle Monomere ethylenisch ungesättigter Mono- oder Dicarbonsäuren d₄) oder Epoxygruppen aufweisende Monomere d₅) enthalten sein.

Als Beispiele für Monomere d₄) seien Acrylsäure, Methacrylsäure, tertiäre Alkylester dieser Säuren, insbesondere tert.-Butylacrylat und Dicarbonsäuren wie Maleinsäure und Fumarsäure oder Derivate dieser Säuren sowie deren Monoester genannt.

Als latent säurefunktionelle Monomere sollen solche Verbindungen verstanden werden, die unter den Polymerisationsbedingungen bzw. bei der Einarbeitung der Olefinpolymerisate in die Formmassen freie Säuregruppen bilden. Als Beispiele hierfür seien Anhydride von Dicarbonsäuren mit bis zu 20 C-Atomen, insbesondere Maleinsäureanhydrid und tertiäre C₁-C₁₂-Alkylester der vorstehend genannten Säuren, insbesondere tert.-Butylacrylat und tert.-Butylmethacrylat angeführt.

Die säurefunktionellen bzw. latent säurefunktionellen Monomeren und die Epoxygruppen-enthaltenden Monomeren werden vorzugsweise durch Zugabe von Verbindungen der allgemeinen Formeln I-IV zum Monomerengemisch in die Olefinpolymerisate eingebaut. 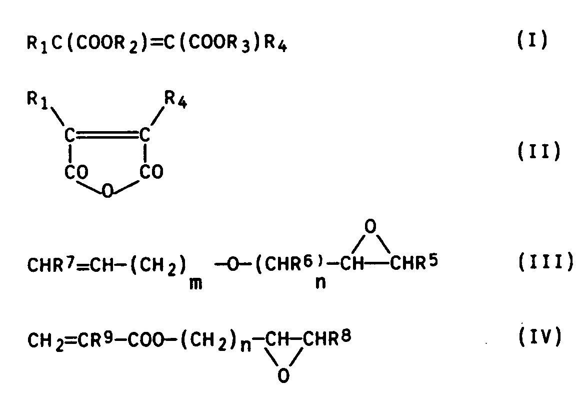
wobei die Reste R¹ - R⁹ Wasserstoff oder Alkylgruppen mit 1 bis 6 C-Atomen darstellen und m eine ganze Zahl von 0 bis 20 und n eine ganze Zahl von 0 bis 10 ist.

Bevorzugt für R¹ - R⁷ ist Wasserstoff, für m der Wert 0 oder 1 und für n der Wert 1. Die entsprechenden Verbindungen sind Maleinsäure, Fumarsäure, Maleinsäureanhydrid, d₄) bzw. Alkenylglycidylether oder Vinylglycidylether d₅).

Bevorzugte Verbindungen der Formeln I, II, III und IV sind Maleinsäure und Maleinsäureanhydrid als Komponente d₄) und Epoxygruppen-enthaltende Ester der Acrylsäure und/oder Methacrylsäure, wobei Glycidylacrylat und Glycidylmethacrylat (als Komponente d₅) besonders bevorzugt werden.

Der Anteil der Komponenten d₄) bzw. d₅) beträgt jeweils 0,07 bis 40 Gew.%, insbesondere 0,1 bis 20 und besonders bevorzugt 0,15 bis 15 Gew.%, bezogen auf das Gesamtgewicht der Olefinpolymerisate.

Besonders bevorzugt sind Olefinpolymerisate aus
50 bis 98,9 insbesondere 60 bis 95 Gew.% Ethylen,
0,1 bis 20, insbesondere 0,15 bis 15 Gew.% Glycidylacrylat und/oder Glycidylmethacrylat, Acrylsäure und/oder Maleinsäureanhydrid,
1 bis 45, insbesondere 10 bis 35 Gew.% n-Butylacrylat und/oder 2-Ethylhexylacrylat.

Weitere bevorzugte Ester der Acryl- und/oder Methacrylsäure sind die Methyl-, Ethyl-, Propyl- und i- bzw. t-Butylester.

Als sonstige Monomere d₆) kommen z.B. Vinylester und Vinylether in Betracht.

Bei der Verwendung solcher Olefinpolymerisate beträgt deren Anteil bevorzugt 0 bis 20, insbesondere 4 bis 18 und ganz besonders 5 bis 15 Gew.%, bezogen auf das Gesamtgewicht der Komponenten (A) bis (D).

Die Herstellung der vorstehend beschriebenen Ethylencopolymeren kann nach an sich bekannten Verfahren erfolgen, vorzugsweise durch statistische Copolymerisation unter hohem Druck und erhöhter Temperatur.

Der Schmelzindex der Ethylencopolymeren liegt im allgemeinen im Bereich von 1 bis 80 g/10 min (gemessen bei 190°C und 2,16 kg Belastung).

Außer den vorstehenden bevorzugten kautschukelastischen Polymerisaten auf Basis von Olefinen eignen sich als Elastomere (D) beispielsweise die folgenden Polymerisate.

In erster Linie sind hier Emulsionspolymerisate zu nennen, deren Herstellung z.B. in Houben-Weyl, Methoden der organischen Chemie, Band XII. I (1961) sowie bei Blackley in der Monographie "Emulsion Polymerisation" beschrieben wird.

Grundsätzlich können statistisch aufgebaute Elastomere oder aber solche mit einem Schalenaufbau eingesetzt werden. Der schalenartige Aufbau wird durch die Zugabereihenfolge der einzelnen Monomeren bestimmt.

Als Monomere für die Herstellung des Kautschukteils der Elastomeren seien Acrylate wie n-Butylacrylat und 2-Ethylhexylacrylat, entsprechende Methacrylate, Butadien und Isopren sowie deren Mischungen genannt. Diese Monomeren können mit weiteren Monomeren wie Styrol, Acrylnitril, Vinylethern und weiteren Acrylaten oder Methacrylaten wie Methylmethacrylat, Methylacrylat, Ethylacrylat und Propylacrylat copolymerisiert werden.

Die Weich- oder Kautschukphase (mit einer Glasübergangstemperatur von unter 0°C) der Elastomeren kann den Kern, die äußere Hülle oder eine mittlere Schale (bei Elastomeren mit mehr als zweischaligem Aufbau) darstellen; bei mehrschaligen Elastomeren können auch mehrere Schalen aus einer Kautschukphase bestehen.

Sind neben der Kautschukphase noch eine oder mehrere Hartkomponenten (mit Glasübergangstemperaturen von mehr als 20°C) am Aufbau des Elastomeren beteiligt, so werden diese im allgemeinen durch Polymerisation von Styrol, Acrylnitril, Methacrylnitril, α-Methylstyrol, p-Methylstyrol, Acrylsäureestern und Methacrylsäureestern wie Methylacrylat, Ethylacrylat und Methylmethacrylat als Hauptmonomeren hergestellt. Daneben können auch hier geringere Anteile an weiteren Comonomeren eingesetzt werden.

In einigen Fällen hat es sich als vorteilhaft herausgestellt, Emulsionspolymerisate einzusetzen, die an der Oberfläche reaktive Gruppen aufweisen. Derartige Gruppen sind z.B. Epoxy-, Carboxyl-, latente Carboxyl-, Amino- oder Amidgruppen sowie funktionelle Gruppen, die durch Mitverwendung von Monomeren der allgemeinen Formel 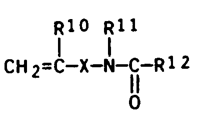
eingeführt werden können,
wobei die Substituenten folgende Bedeutung haben können:
- R¹⁰: Wasserstoff, oder eine C₁-C₄-Alkylgruppe,
- R¹¹: Wasserstoff, eine C₁-C₈-Alkylgruppe oder eine Arylgruppe, insbesondere Phenyl,
- R¹²: Wasserstoff, eine C₁-C₁₀-Alkyl-, eine C₆-C₁₂-Arylgruppe oder OR¹³,
- R¹³: eine C₁-C₈-Alkyl- oder C₆-C₁₂-Arylgruppe, die gegebenenfalls mit O- oder N-haltigen Gruppen substituiert sein können,
- X: eine chemische Bindung, eine C₁-C₁₀-Alkylen- oder C₆-C₁₂-Arylengruppe oder 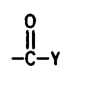
- Y: O-Z- oder NH-Z und
- Z: eine C₁-C₁₀-Alkylen- oder C₆-C₁₂-Arylengruppe.

Auch die in der EP-A 208 187 beschriebenen Pfropfmonomeren sind zur Einführung reaktiver Gruppen an der Oberfläche geeignet.

Als weitere Beispiele seien noch Acrylamid, Methacrylamid und substituierte Ester der Acrylsäure oder Methacrylsäure wie (N-t-Butylamino)ethylmethacrylat, (N,N-Dimethylamino)ethylacrylat, (N,N-Dimethylamino)methylacrylat und (N,N-Diethylamino)ethylacrylat genannt.

Weiterhin können die Teilchen der Kautschukphase auch vernetzt sein. Als Vernetzer wirkende Monomere sind beispielsweise Buta-1,3-dien, Divinylbenzol, Diallylphthalat und Dihydrodicyclopentodienylacrylat sowie die in der EP-A 50 265 beschriebenen Verbindungen.

Ferner können auch sogenannten pfropfvernetzende Monomere (graft-linking monomers) verwendet werden, d.h. Monomere mit zwei oder mehr polymerisierbaren Doppelbindungen, die bei der Polymerisation mit unterschiedlichen Geschwindigkeiten reagieren. Vorzugsweise werden solche Verbindungen verwendet, in denen mindestens eine Doppelbindung mit etwa gleicher Geschwindigkeit wie die übrigen Monomeren polymerisiert, während der restliche Teil der Doppelbindungen deutlich langsamer polymerisiert. Die unterschiedlichen Polymerisationsgeschwindigkeiten bringen einen bestimmten Anteil an ungesättigten Doppelbindungen im Kautschuk mit sich. Wird anschließend auf einen solchen Kautschuk eine weitere Phase aufgepfropft, so reagieren die im Kautschuk vorhandenen Doppelbindungen zumindest teilweise mit den Pfropfmonomeren unter Ausbildung von chemischen Bindungen, d.h. die aufgepfropfte Phase ist zumindest teilweise über chemische Bindungen mit der Pfropfgrundlage verknüpft.

Beispiele für solche pfropfvernetzende Monomere sind Allylgruppen enthaltende Monomere, insbesondere Allylester von ethylenisch ungesättigten Carbonsäuren wie Allylacrylat, Allylmethacrylat, Diallylmaleat, Diallylfumarat, Diallylitaconat oder die entsprechenden Monoallylverbindungen dieser Dicarbonsäuren. Daneben gibt es eine Vielzahl weiterer geeigneter pfropfvernetzender Monomerer; für nähere Einzelheiten sei hier beispielsweise auf die US-PS 4 148 846 verwiesen.

Im allgemeinen beträgt der Anteil dieser vernetzenden Monomeren an der Komponente (D) bis zu 5 Gew.%, vorzugsweise nicht mehr als 3 Gew.%, bezogen auf (D).

Im folgenden seien einige bevorzugte Emulsionspolymerisate aufgeführt. Zunächst sind hier Pfropfpolymerisate mit einem Kern und mindestens einer äußeren Schale zu nennen, die folgenden Aufbau haben:

| Typ | Monomere für den Kern | Monomere für die Hülle |
|---|---|---|
| D/1 | Buta-1,3-dien, Isopren, n-Butylacrylat, Ethylhexylacrylat oder deren Mischungen | Styrol, Acrylnitril, Methylmethacrylat |
| D/2 | wie A aber unter Mitverwendung von Vernetzern | wie A |
| D/3 | wie A oder B | n-Butylacrylat, Ethylacrylat, Methylacrylat, Buta-1,3-dien, Isopren, Ethylhexylacrylat |
| D/4 | wie A oder B | wie A oder C aber unter Mitverwendung von Monomeren mit reaktiven Gruppen wie hierin beschrieben |
| D/5 | Styrol, Acrylnitril, Methylmethacrylat oder deren Mischungen | erste Hülle aus Monomeren wie unter A und B für den Kern beschrieben |
| | | zweite Hülle wie unter A oder C für die Hülle beschrieben |

Anstelle von Pfropfpolymerisaten mit einem mehrschaligen Aufbau können auch homogene, d.h. einschalige Elastomere aus Buta-1,3-dien, Isopren und n-Butylacrylat oder deren Copolymeren eingesetzt werden. Auch diese Produkte können durch Mitverwendung von vernetzenden Monomeren oder Monomeren mit reaktiven Gruppen hergestellt werden.

Beispiele für bevorzugte Emulsionspolymerisate sind n-Butylacrylat/(Meth)acrylsäure-Copolymere, n-Butylacrylat/Glycidylacrylat- oder n-Butylacrylat/Glycidylmethacrylat-Copolymere, Pfropfpolymerisate mit einem inneren Kern aus n-Butylacrylat oder auf Butadienbasis und einer äußeren Hülle aus den vorstehend genannten Copolymeren und Copolymere von Ethylen mit Comonomeren, die reaktive Gruppen liefern.

Die beschriebenen Elastomere (D) können auch nach anderen üblichen Verfahren, z.B. durch Suspensionspolymerisation, hergestellt werden.

Neben den wesentlichen Komponenten (A) und (B) und gegebenenfalls (C) und (D) können die erfindungsgemäßen Formmassen übliche Zusatzstoffe und Verarbeitungshilfsmittel enthalten. Deren Anteil beträgt im allgemeinen bis zu 20, vorzugsweise bis zu 10 Gew.%, bezogen auf das Gesamtgewicht der Komponenten (A) bis (D).

Übliche Zusatzstoffe sind beispielsweise Stabilisatoren und Oxidationsverzögerer, Mittel gegen Wärmezersetzung und Zersetzung durch ultraviolettes Licht, Gleit- und Entformungsmittel, Farbstoffe und Pigmente und Weichmacher.

Oxidationsverzögerer und Wärmestabilisatoren, die den thermoplastischen Massen gemäß der Erfindung zugesetzt werden können, sind z.B. Halogenide von Metallen der Gruppe I des Periodensystems, z.B. Natrium-, Kalium-, Lithium-Halogenide, ggf. in Verbindung mit Kupfer-(I)-Halogeniden, z.B. Chloriden, Bromiden oder Iodiden. Weiterhin können Zinkfluorid und Zinkchlorid verwendet werden. Ferner sind sterisch gehinderte Phenole, Hydrochinone, substituierte Vertreter dieser Gruppe und Mischungen dieser Verbindungen, vorzugsweise in Konzentrationen bis zu 1 Gew.%, bezogen auf das Gewicht der Mischung, einsetzbar.

Beispiele für UV-Stabilisatoren sind verschiedene substituierte Resorcine, Salicylate, Benzotriazole und Benzophenone, die im allgemeinen in Mengen bis zu 2 Gew.% eingesetzt werden.

Gleit- und Entformungsmittel, die in der Regel in Mengen bis zu 1 Gew.% der thermoplastischen Masse zugesetzt werden, sind Stearinsäure, Stearylalkohol, Stearinsäurealkylester und -amide sowie Ester des Pentaerythrits mit langkettigen Fettsäuren.

Unter den Zusatzstoffen sind auch Stabilisatoren, die die Zersetzung des roten Phosphors in Gegenwart von Feuchtigkeit und Luftsauerstoff verhindern. Als Beispiele seien Verbindungen des Cadmiums, Zinks, Aluminiums, Zinns, Magnesiums, Mangans und Titans genannt. Besonders geeignete Verbindungen sind z.B. Oxide der genannten Metalle, ferner Carbonate oder Oxicarbonate, Hydroxide sowie Salze organischer oder anorganischer Säuren wie Acetate oder Phosphate bzw. Hydrogenphosphate.

Die erfindungsgemäßen thermoplastischen Formmassen können nach an sich bekannten Verfahren hergestellt werden, indem man die Ausgangskomponenten in üblichen Mischvorrichtungen wie Schneckenextrudern, Brabender-Mühlen oder Banbury-Mühlen mischt und anschließend extrudiert. Nach der Extrusion wird das Extrudat abgekühlt und zerkleinert. Die Mischtemperaturen liegen dabei im allgemeinen im Bereich von 270 - 330°C.

Die erfindungsgemäßen flammgeschützten Formmassen zeichnen sich durch eine gute Phosphorstabilität und ein ausgewogenes Eigenschaftsspektrum aus.

Besonders bevorzugte Formmassen sind gekennzeichnet durch folgende Zusammensetzung:
A) 40 - 99 Gew.% des teilaromatischen Copolyamids,
B) 1 - 40 Gew.% der Flammschutzmittelkombination aus
   b₁) 40 - 90 Gew.% rotem Phosphor,
   b₂) 5 - 50 Gew.% Zinkoxid oder Cadmiumoxid oder deren Mischungen,
   b₃) 1 - 40 Gew.% Stearylstearat, Zinkstearat, Aluminiumstearat, Calciumstearat oder deren Mischungen.

Daher eignen sie sich zur Herstellung von Fasern, Folien und Formkörpern, wobei wegen der guten Phosphorstabilität insbesondere die Verwendung im Elektronikbereich, z.B. zur Herstellung von elektrischen Steckverbindern und Leiterplattensubstraten erwähnenswert ist.

### Beispiele

Zur Herstellung thermoplastischer Formmassen wurden folgende Komponenten eingesetzt:

### Komponente A

- A/1: Teilaromatisches Copolyamid aus Einheiten a₁ und a₂ im Verhältnis 70:30 mit einer relativen Viskosität von 2,50 (in 1 g/100 ml in 98 gew.%iger H₂SO₄ bestimmt), hergestellt nach dem in der EP-A 129 195 beschriebenen Verfahren. Der Triamingehalt betrug etwa 0,2 Gew.%.
- A/V: Polyhexamethylenadipinsäureamid mit einer ηᵣₑₗ von 2,70 (gemessen wie bei A/1; Ultramid® A3 der BASF)

### Komponente B

- b₁: Roter Phosphor (Exolit® 385 der Hoechst-Knapsack)
- b₂/1: Zinkoxid
- b₂/2: Cadmiumoxid
- b₃: Sebazinsäure
- b₄: Stearylstearat

### C Glasfasern

Die Komponenten A, b₁-b₄ und C wurden auf einen Zweischneckenextruder der Fa. Werner & Pfleiderer bei 310°C gemischt, extrudiert und granuliert. Zur Bestimmung der Phosphorstabilität wurden aus dem Granulat Normkleinstäbe (50 x 6 x 4 mm) gespritzt und in einem offenen Gefäß bei 60°C in 150 ml Wasser gelagert, wobei die Wassermenge konstant gehalten wurde.

Nach 14,30 und 50 Tagen wurden aus der wäßrigen Phase Proben entnommen und darin die Gesamtmenge an gelöster Phosphorverbindungen bestimmt.

Die Zusammensetzung der einzelnen Massen und die Ergebnisse der Bestimmungen sind der Tabelle zu entnehmen.

**Tabelle**

| (V = Vergleichsbeispiele) | | | | | |
|---|---|---|---|---|---|
| Komp. | Beispiel | | | | |
| | 1 | 2 | 3V | 4V | 5V |
| A [Gew.%] | 66,95 A/1 | 66,85 A/1 | 67,65 A/1 | 67,85 A/V | 67,05 A/V |
| b₁ [Gew.%] | 6,8 | 6,8 | 6,8 | 6,8 | 6,8 |
| b₂ [Gew.%] | 0,7 b₂/1 | 0,8 b₂/2 | - | - | 0,8 b₂/1 |
| b₃ [Gew.%] | 0,2 | 0,2 | 0,2 | - | - |
| b₄ (Gew.%] | 0,35 | 0,35 | 0,35 | 0,35 | 0,35 |
| C | 25,0 | 25,0 | 25,0 | 25,0 | 25,0 |

| gelöster Phosphor [ppm] | | | | | |
|---|---|---|---|---|---|
| nach 14 Tagen | 6 | 7 | 15 | 185 | 50 |
| nach 30 Tagen | 16 | 20 | 37 | 315 | 56 |
| nach 50 Tagen | 32 | 45 | 85 | 445 | 91 |

Bei den Massen der erfindungsgemäßen Beispiele 1 und 2 waren keine Molekulargewichtsveränderungen der Komponente A zu beobachten, während im Beispiel 3V ein Aufbau des Molekulargewichts beobachtet wurde.

Insgesamt zeigen die Beispiele die vorteilhaften Eigenschaften der erfindungsgemäßen Formmassen und den Einfluß der Zusammensetzung der Flammschutzmittelkombination auf die Phosphorstabilität. Insbesondere bemerkenswert ist, daß ZnO bessere Ergebnisse als CdO liefert, was bei herkömmlichen Polyamiden in der Regel nicht der Fall ist (dort ist CdO im allgemeinen von besserer Wirkung als ZnO). Dies ist wegen der toxischen Bedenken gegen CdO ein erheblicher Vorteil.

## Patentansprüche

1. Flammfeste thermoplastische Formmassen, enthaltend
A) 40 - 99 Gew.-% eines teilaromatischen Copolyamids, aufgebaut aus
a₁) 40 - 90 Gew.-% Einheiten, die sich von Terephthalsäure und Hexamethylendiamin ableiten,
a₂) 0 - 50 Gew.-% Einheiten, die sich von ε-Caprolactam ableiten und
a₁) 0 - 60 Gew.-% Einheiten, die sich von Adipinsäure und Hexamethylendiamin ableiten,
wobei die Komponente a₂) und/oder a₃) insgesamt mindestens 10 Gew.-% der Gesamteinheiten ausmachen, und nicht mehr als 15 Gew.-% an weiteren Polyamidbausteinen, bezogen auf a₁) bis a₃) enthalten sind.
B) 1 - 40 Gew.-% einer Flammschutzmittelkombination aus
b₁) 40 - 97 Gew.-% rotem Phosphor,
b₂) 1 - 50 Gew.-% einer anorganischen Verbindung eines zwei- oder vierwertigen Metalls,
b₃) 1 - 50 Gew.-% einer anorganischen Mono- oder Dicarborsäure, und
b₄) 1 - 40 Gew.-% eines Esters einer organischen Carbonsäure mit 6 bis 24 C-Atomen mit einem Alkohol mit 2 bis 24 C-Atomen oder eines Metallsalzes einer solchen Säure oder deren Mischungen
C) 0 - 60 Gew.-% faser- oder teilchenförmige Füllstoffe, ausgewählt aus der Gruppe aus Glasfasern, Kohlenstoffasern, Aramid-Fasern, Kaliumtitanatfasern, faser- oder teilchenförmige Silikate, Quarzmehl, Bornitrid, Kaolin, Glaskugeln, oder deren Mischungen, und
D) 0 - 40 Gew.-% eines schlagzäh modifizierenden Polymeren.

2. Flammfeste thermoplastische Formmassen nach Anspruch 1, dadurch gekennzeichnet, daß als Metalloxid b₂) Zinkoxid, Cadmiumoxid oder eine Mischung aus Zinkoxid und Cadmiumoxid enthalten ist.

3. Flammfeste thermoplastische Formmassen nach Anspruch 1 oder 2, dadurch gekennzeichnet, daß als Komponente b₃) Sebazinsäure enthalten ist.

4. Flammfeste thermoplastische Formmassen nach einem der Ansprüche 1 bis 3, dadurch gekennzeichnet, daß als Komponente b₄) ein Ester der Stearinsäure mit einem Alkohol mit 6 bis 24 C-Atomen oder einem Aluminium-, Zink- oder Calciumsalz der Stearinsäure oder eine Mischung dieser Verbindungen enthalten ist.

5. Flammfeste thermoplastische Formmassen nach den Ansprüchen 1 bis 4, gekennzeichnet durch folgende Zusammensetzung:
A) 40-99 Gew.% des teilaromatischen Copolyamids
B) 1-40 Gew.% der Flammschutzmittelkombination aus
b₁) 40-90 Gew.% rotem Phosphor
b₂) 5-50 Gew.% Zinkoxid oder Cadmiumoxid oder deren Mischungen
b₃) 1-40 Gew.% Sebacinsäure
b₄) 1-40 Gew.% Stearylstearat, Zinkstearat, Aluminiumstearat, Calciumstearat oder deren Mischungen.

6. Verwendung der thermoplastischen Formmassen gemäß einem der Ansprüche 1 bis 5 zur Herstellung von Fasern, Folien und Formkörpern.

7. Leiterplattensubstrat, hergestellt aus thermoplastischen Formmassen gemäß einem der Ansprüche 1 bis 5.

8. Elektrische Steckverbinder, hergestellt aus thermoplastischen Formmassen gemäß einem der Ansprüche 1 bis 5.

## Claims

1. A flameproofed thermoplastic molding material, containing
A) 40-99% by weight of a partly aromatic amide copoly mer consisting of
a₁) 40-90% by weight of units derived from terephthalic acid and hexamethylenediamine,
a₂) 0-50% by weight of units derived from ε-caprolactam and
a₃) 0-60% by weight of units derived from adipic acid and hexamethylenediamine,
component a₂) and/or a₃) accounting altogether for not less than 10% by weight of the total number of units, and not more than 15% by weight, based on a₁) to a₃), are present, of further polyamide units,
B) 1-40% by weight of a flameproofing combination of
b₁) 40-97% by weight of red phosphorus,
b₂) 1-50% by weight of an inorganic compound of a divalent or tetravalent metal,
b₃) 1-50% by weight of an organic mono- or dicarboxylic acid and
b₄) 1-40% by weight of an ester of an organic carboxylic acid of 6 to 24 carbon atoms with an alcohol of 2 to 24 carbon atoms or of a metal salt of such an acid, or a mixture of these,
C) 0-60% by weight of fibrous or particulate fillers selected from the group consisting of glass fibers, carbon fibers, Aramid fibers, potassium titanate fibers, fibrous or particulate silicates, quartz powder, boron nitride, kaolin and glass spheres, or a mixture of these, and
D) 0-40% by weight of a polymeric impact modifier.

2. A flameproofed thermoplastic molding material as claimed in claim 1, wherein zinc oxide, cadmium oxide or a mixture of zinc oxide and cadmium oxide is present as metal oxide b₂).

3. A flameproofed thermoplastic molding material as claimed in claim 1 or 2, wherein sebacic acid is present as component b₃).

4. A flameproofed thermoplastic molding material as claimed in any of claims 1 to 3, wherein an ester of stearic acid with an alcohol of 6 to 24 carbon atoms or an aluminum, zinc or calcium salt of stearic acid or a mixture of these compounds is present as component b₄).

5. A flameproofed thermoplastic molding material as claimed in any of claims 1 to 4, which has the following composition:
A) 40-99% by weight of a partly aromatic amide copolymer
B) 1-40% by weight of a flameproofing combination of
b₁) 40-90% by weight of red phosphorus
b₂) 5-50% by weight of zinc oxide or cadmium oxide or a mixture of these
b₃) 1-40% by weight of sebacic acid
b₄) 1-40% by weight of stearyl stearate, zinc stearate, aluminum stearate, calcium stearate or a mixture of these.

6. The use of a thermoplastic molding material as claimed in any of claims 1 to 5 for producing fibers, films and moldings.

7. A circuit board substrate produced from a thermoplastic molding material as claimed in any of claims 1 to 5.

8. An electrical plug connector produced from a thermoplastic molding material as claimed in any of claims 1 to 5.

## Revendications

1. Masses à mouler thermoplastiques résistant à l'action du feu, contenant
A) 40-99% en poids d'un copolyamide partiellement aromatique, composé de
a₁) 40-90% en poids de motifs qui dérivent d'acide téréphtalique et d'hexaméthylènediamine,
a₂) 0-50% en poids de motifs qui dérivent d'ε-caprolactame et
a₃) 0-60% en poids de motifs qui dérivent d'acide adipique et d'hexaméthylènediamine,
les composants a₂) et/ou a₃) constituant au total au moins 10% en poids des motifs totaux, et pas plus de 15% en poids d'autres éléments structuraux, par rapport à a₁)-a₃), étant contenus dans le polyamide,
B) 1-40% en poids d'une combinaison d'agents retardant les flammes, composée de
b₁) 40-97% en poids de phosphore rouge,
b₂) 1-50% en poids d'un composé inorganique d'un métal bi- ou tétravalent,
b₃) 1-50% en poids d'un acide mono- ou dicarboxylique inorganique et
b₄) 1-40% en poids d'un ester d'un acide carboxylique organique à 6-24 atomes de carbone avec un alcool à 2-24 atomes de carbone, d'un sel métallique d'un tel acide ou de mélanges de ceux-ci,
C) 0-60% en poids de charges en forme de fibres ou de particules, choisies dans le groupe constitué par les fibres de verre, les fibres de carbone, les fibres d'aramide, les fibres de titanate de potassium, les silicates en fibres ou en particules, la poudre de quartz, le nitrure de bore, le kaolin, les billes de verre ou des mélanges de ceux-ci, et
D) 0-40% en poids d'un polymère modifiant la résilience.

2. Masses à mouler thermoplastiques résistant à l'action du feu selon la revendication 1, caractérisées en ce que de l'oxyde de zinc, de l'oxyde de cadmium ou un mélange d'oxyde de zinc et d'oxyde de cadmium y est contenu en tant qu'oxyde métallique b₂).

3. Masses à mouler thermoplastiques résistant à l'action du feu selon la revendication 1 ou 2, caractérisées en ce que de l'acide sébacique y est contenu en tant que composant b₃).

4. Masses à mouler thermoplastiques résistant à l'action du feu selon l'une quelconque des revendications 1 à 3, caractérisées en ce qu'un ester de l'acide stéarique avec un alcool à 6-24 atomes de carbone, un sel d'aluminium, de zinc ou de calcium de l'acide stéarique ou un mélange de ces composés y est contenu en tant que composant b₄).

5. Masses à mouler thermoplastiques résistant à l'action du feu selon l'une quelconque des revendications 1 à 4, caractérisées par la composition suivante:
A) 40-99% en poids du copolyamide partiellement aromatique,
B) 1-40% en poids de la combinaison d'agents retardant les flammes composée de
b₁) 40-90% en poids de phosphore rouge,
b₂) 5-50% en poids d'oxyde de zinc, d'oxyde de cadmium ou de mélanges de ceux-ci,
b₃) 1-40% en poids d'acide sébacique,
b₄) 1-40% en poids de stéarate de stéaryle, de stéarate de zinc, de stéarate d'aluminium, de stéarate de calcium ou de mélanges de ceux-ci.

6. Utilisation des masses à mouler thermoplastiques selon l'une quelconque des revendications 1 à 5 pour la fabrication de fibres, de feuilles et de corps moulés.

7. Substrat de carte de circuits imprimés, fabriqué à partir de masses à mouler thermoplastiques selon l'une quelconque des revendications 1 à 5.

8. Connecteur électrique multibroches, fabriqué à partir de masses à mouler thermoplastiques selon l'une quelconque des revendications 1 à 5.
